# EUROPEAN PATENT APPLICATION

(11) **EP 4 633 305 A1**
(43) Date of publication of application: **15.10.2025**
(21) Application number: 24169274.8
(22) Date of filing: 09.04.2024
(51) Int. Cl.: H05K 7/20

(54) **MONITORING A COOLANT FLOW OF A POWER ELECTRONIC SEMICONDUCTOR DEVICE**

(71) Applicant: Airbus S.A.S., 31700 Blagnac (FR)
(72) Inventor: STEINER, Gerhard, 82024 Taufkirchen (DE); KAPAUN, Florian, 82024 Taufkirchen (DE)
(74) Representative: OTN Airbus SAS

(57) **Abstract**

The invention relates to a method for monitoring a cooling system for power electronics, especially on aircraft. For improving monitoring of a cooling system (18) of a power electronic semiconductor device (14), wherein the cooling system (18) is configured to generate a coolant flow (28, 28.1-28.4) along a coolant flow path over at least one semiconductor power module (20.1-20.3) of the power electronic semiconductor device, the invention proposes a method with the steps:
a) providing several temperature sensors (22.1-22.3) arranged along the coolant flow path,
b) measuring temperatures at different locations of the coolant flow path by means of the temperature sensors (22.1-22.3),
c) comparing an actual temperature difference between the temperatures measured in step b) with an expected temperature difference calculated on basis of losses of the at least one semiconductor power module (20.1-20.3) and on basis of nominal coolant flow conditions;
d) determining the status of the coolant flow on basis of the comparison of step c).

## Description

The invention relates to a monitoring method for monitoring a cooling system of a power electronic semiconductor device that includes at least one semiconductor power module including a power switching element and the cooling system configured to generate a coolant flow along a coolant flow path over the at least one semiconductor power module. Further, the invention relates to a monitoring unit configured to conduct such a monitoring, a power electronic semiconductor device equipped with such a monitoring unit, and an aircraft with such a power electronic semiconductor device.

The invention relates to the field of power semiconductor electronics with its corresponding cooling system. The principles of the invention are applicable to any power semiconductor module. For example, according to some embodiments of the invention, an electrical switch in form of a power electronic semiconductor device with transistors or other electronic power switching elements on a semiconductor power module is meant to replace mechanical switches. The electronic solution has many advantages over the mechanical solution, e.g., with regard to reaction time. Unfortunately, cooling is required due to the higher on state losses of the electrical switch.

In order to ensure correct operation of a power semiconductor module, the cooling system (e.g., a proper coolant flow provided thereby) should be monitored.

For technical background, reference is made to the following literatures:
[1] Wikipedia, Power Module, retrieved from
   https://en.wikipedia.org/w/index.php?title=Power_module&oldid=1103087500 on July 20, 2023
[2] Wikipedia, DC-to-DC Converter, retrieved from
   https://en.wikipedia.org/w/index.php?title=DC-to-DC_converter&oldid=1142364570 on July 20, 2023
[3] Wikipedia, Switched-mode power supply, retrieved from
   https:/Ien.wikipedia.org/w/index.php?title=Switched-mode_power_supply&oldid=1164879008 on July 20, 2023

Literatures [1] to [3] describe examples for the power electronics semiconductor devices which are also used in some embodiments of the invention.

Actual solutions use temperature sensitive resistive devices or diode forward voltage to measure temperature on semiconductor power modules.

An object of the invention is to provide an improved monitoring method and an improved monitoring unit for monitoring a cooling system of at least one power module, especially of an aircraft.

For achieving such object, the invention provides a monitoring method according to claim 1 and a monitoring unit according to claim 8. A power electronic semiconductor device and an aircraft comprising such monitoring unit as well as a computing device and a computer program for controlling the process of such monitoring method are subject-matters of the further independent claims.

Advantageous embodiments are subject-matters of the dependent claims.

The invention provides a monitoring method for monitoring a cooling system of a power electronic semiconductor device that includes at least one semiconductor power module including a power switching element and the cooling system configured to generate a coolant flow along a coolant flow path over the at least one semiconductor power module, comprising:
a) providing several temperature sensors arranged along the coolant flow path,
b) measuring temperatures at different locations of the coolant flow path by means of the temperature sensors,
c) comparing an actual temperature difference between (at least two of the) temperatures measured in step b) with an expected temperature difference calculated on basis of losses of the at least one semiconductor power module and on basis of nominal coolant flow conditions;
d) determining the status of the coolant flow on basis of the comparison of step c).

In some embodiments, step a) comprises the step:
a1) providing the temperature sensors integrated on several semiconductor modules arranged along the coolant flow path.

In some embodiments, step a) comprises the step:
a2) providing an upstream temperature sensor on a position of the coolant medium flow path upstream of the at least one semiconductor power module and a downstream temperature sensor on a position of the coolant flow path downstream of the at least one semiconductor power module.

In some embodiments, step a) comprises the step:
a3) providing first, second, and third temperature sensors along at least a portion of the coolant flow path.

In some embodiments, step b) comprises the step:
b1) measuring an inlet temperature and an outlet temperature of the coolant.

In some embodiments, step b) comprises the step:
b2) measuring a temperature at the position of the semiconductor power module.

In some embodiments, step b) comprises the step:
b3) determining a mean temperature of temperatures measured by the several temperature sensors.

In some embodiments, step b) comprises the step:
b4) determining a temperature difference between at least two of the temperature sensors.

In some embodiments, step b) comprises the step:
b5) determining a temperature change over time for at least one, several or all of the temperature sensors.

In some embodiments, step c) comprises the step:
c1) calculating an expected temperature difference on basis of power losses in several semiconductor modules.

In some embodiments, step c) comprises the step:
c2) calculating the expected temperature difference on basis of the properties of the coolant.

In some embodiments, step c) comprises the step:
c3) calculating the expected temperature difference on basis of the intended or nominal coolant flow rate.

In some embodiments, step c) comprises the step:
c4) calculating an expected mean temperature of the temperature values to be measured by the temperature sensor on basis of the losses and the nominal flow conditions.

In some embodiments, step c) comprises the step:
c5) determining the actual temperature difference on basis of a difference between an outlet temperature and an inlet temperature of the coolant.

In some embodiments, step c) comprises the step:
c6) determining a difference between the actual temperature difference and the expected temperature difference.

In some embodiments, step c) comprises the step:
c7) comparing an actual temperature change with an expected temperature change.

In some embodiments, the temperature change over time is determined for the at least one, several or all of the temperature sensor. In some embodiments, expected values for this temperature change(s) are determined similar to the determination of expected temperature differences, e.g. on basis of losses and nominal coolant flow conditions.

In some embodiments, step c) comprises the step:
c8) determining thresholds for the temperature difference, the mean temperature and the temperature change(s) on basis of calculated losses and nominal coolant flow conditions.

In some embodiments, step d) comprises the step:
d1) determining that the coolant flow is okay when the actual temperature difference is the expected temperature difference or within a predetermined temperature difference range determined on basis of the expected temperature difference.
d3) determining that the coolant flow is okay when all of the following conditions are fulfilled:
   - the actual temperature difference is the expected temperature difference or within a predetermined temperature difference range determined on basis of the expected temperature difference,
   - the actual mean temperature is equal or lower than the expected mean temperature or equal or lower than a predetermined mean temperature threshold determined on basis of the expected mean temperature; and
   - the actual temperature change is equal or smaller than the expected temperature change or equal or smaller than a predetermined temperature change threshold determined on basis of the expected temperature change.

In some embodiments, step d) comprises the step:
d2) determining that the coolant flow is okay when both of the following conditions are fulfilled:
- the actual temperature difference is the expected temperature difference or within a predetermined temperature difference range determined on basis of the expected temperature difference, and
- the actual mean temperature is equal or lower than the expected mean temperature or equal or lower than a predetermined mean temperature threshold determined on basis of the expected mean temperature.

In some embodiments, step d) comprises the step:
d3) determining that the coolant flow is okay when all of the following conditions are fulfilled:
- the actual temperature difference is the expected temperature difference or within a predetermined temperature difference range determined on basis of the expected temperature difference,
- the actual mean temperature is equal or lower than the expected mean temperature or equal or lower than a predetermined mean temperature threshold determined on basis of the expected mean temperature; and
- the actual temperature slope is equal or smaller than the expected temperature slope or equal or smaller than a predetermined temperature slope threshold determined on basis of the expected temperature slope.

In some embodiments, step d) comprises the step:
d4) determining that the coolant flow is too low when the actual temperature difference is higher than the expected temperature difference or higher than a predetermined temperature difference threshold determined on basis of the expected temperature difference.

In some embodiments, step d) comprises the step:
d5) determining that the coolant flow is too low when one or both of the following conditions are fulfilled:
- the actual temperature difference is higher than the expected temperature difference or higher than a predetermined temperature difference threshold determined on basis of the expected temperature difference, and
- the actual mean temperature is higher than the expected mean temperature or a predetermined mean temperature threshold determined on basis of the expected mean temperature.

In some embodiments, step d) comprises the step:
d6) determining that the coolant flow is blocked when the actual temperature difference is lower than the expected temperature difference or lower than a predetermined temperature difference threshold determined on basis of the expected temperature difference.

In some embodiments, step d) comprises the step:
d7) determining that the coolant flow is blocked when at least two or all of the following conditions are fulfilled:
- the actual temperature difference is lower than the expected temperature difference or lower than a predetermined temperature difference threshold determined on basis of the expected temperature difference, and
- the actual mean temperature is higher than the expected mean temperature or a predetermined mean temperature threshold determined on basis of the expected mean temperature;
- the actual temperature change is steeper than the expected temperature change or steeper than a predetermined temperature change threshold determined on basis of the expected temperature change.

According to another aspect, the invention provides a monitoring unit for monitoring a cooling system of a power electronic semiconductor device that includes at least one semiconductor power module including a power switching element and the cooling system configured to generate a coolant flow along a coolant flow path over the at least one semiconductor power module, the monitoring unit comprising:
several temperature sensors arranged along the coolant flow path, and
a computing unit configured to compare an actual temperature difference between the temperatures measured by the several temperature sensors along the coolant flow path with an expected temperature difference calculated on basis of losses of the at least one semiconductor power module and on basis of nominal coolant flow conditions and for determining the status of the coolant flow on basis of this comparison.

Preferably, the monitoring unit is configured to conduct the monitoring method according to any of the aforementioned embodiments.

According to another aspect, the invention provides a power electronic semiconductor device comprising a cooling system, at least one semiconductor power module including a power switching element, and a monitoring unit according to any of the aforementioned embodiments.

In some embodiments, the power electronic semiconductor device comprises not only one but several of the semiconductor power modules, wherein the cooling system is configured to generate the coolant flow over the semiconductor power modules so that coolant flows from one module to the other, and wherein the temperature sensors of the monitoring unit are integrated in the semiconductor power modules. Especially, a first temperature sensor is integrated in a first semiconductor power module, a second temperature sensor is integrated in a second semiconductor power module, and a third temperature sensor is integrated in a third semiconductor power module. In some embodiments, the first semiconductor power module is arranged, with regard to the coolant flow path, upstream of the second semiconductor power module, and the third semiconductor power module is arranged downstream of the second semiconductor power module. In other words, in a nominal condition, the coolant flows to the first semiconductor power module, then from the first to the second semiconductor power module, and then from the second to the third semiconductor power module. The coolant flow is monitored by means of the first to third temperature sensors together with special monitoring routines.

In some embodiments, the power electronic semiconductor device further comprises a housing, wherein the cooling system is configured to provide a coolant flow within the housing and the temperature sensors are in indirect contact with the coolant.

According to another aspect, the invention provides an aircraft comprising a power electronic semiconductor device according to any of the aforementioned embodiments. According to another aspect, the invention provides an aircraft comprising a monitoring unit according to any of the aforementioned embodiments.

According to another aspect, the invention provides a computing unit for a monitoring unit according to any of the aforementioned embodiments, configured to control the monitoring unit to conduct the monitoring method according to any of the aforementioned embodiments of the method.

According to another aspect, the invention provides a computer program comprising instructions to cause the power electronic semiconductor device or the monitoring unit according to any of the aforementioned embodiments to execute the steps of the method of any of the aforementioned embodiments.

Especially, the invention is related to temperature sensing of semiconductor power modules.

Preferred embodiments of the invention relate to power electronics coolant monitoring with on chip NTC (examples for the temperature sensors).

Presently, temperature sensitive resistive devices or diode forward voltage are used to measure temperature on semiconductor power modules. This approach however provides only temperatures, no information or indication if the coolant flow is in the designed range. For flow measurement dedicated flow sensors have to be used in prior approaches.

Preferred embodiments of the invention aim at saving separate flow sensors by using several, module integrated sensors. In some embodiments, the coolant flow status is based on a calculation which includes the calculated losses and the expected results of nominal coolant flow conditions.

Embodiments of the invention enable saving additional flow sensors while keeping a good quality of coolant flow monitoring. Therefore, space and cost can be saved. Also, the redundancy aspect is considered: For absolute temperature monitoring of the coolant a single sensor is sufficient, therefore a failure of the second sensor disables the flow detection but not the absolute coolant temperature measurement. Thus, embodiments of the invention provide a coolant monitoring that is especially enhanced for use on aircraft.

In some embodiments, the integrated temperature sensor on standard power modules is used not just for temperature estimation of the module itself, but also for determining the status of a coolant flow. Thus, the health status of the cooling system can be concluded on basis of the determined status of the coolant flow without the need of additional flow sensors.

Embodiments of the invention are explained below referring to the accompanying drawings in which:
- Fig. 1: a schematic view of an aircraft with an electronic device and a power module for supplying the electronic circuit with electrical power;
- Fig. 2: a schematic view of a power electronic semiconductor device several semiconductor power modules with integrated temperature sensors and a cooling system for generating a coolant flow over the several semiconductor power modules;
- Fig. 3: a graph showing the temperatures measured by the temperature sensors over the distance from a source of the coolant flow for different statuses of the coolant flow.

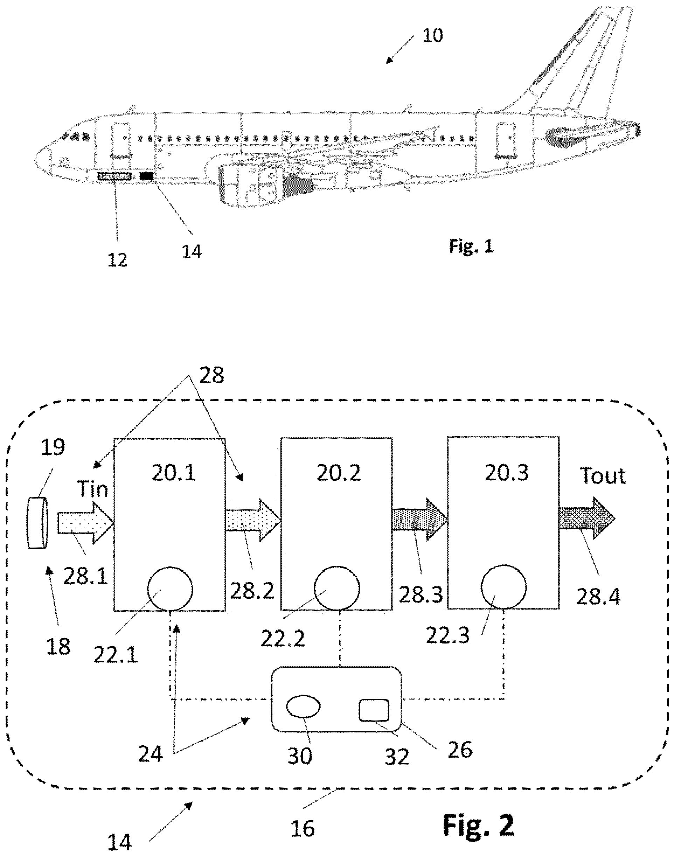

Fig. 1 shows an aircraft 10 with an electronic device 12 and a power electronic semiconductor device 14 for supplying the electronic device 12 with electrical power. The electronic device 12 can be any electronic device to be used on the aircraft 10, such as a part of a flight computer, a flight controller, an electronic instrument, a computing device, a personal computer, a communication device, a transmitter, a receiver, an electric motor, or a part of a passenger entertainment system. In other embodiments, the power electronic semiconductor device 14 is used for supplying other aircraft components such as electric motors, electric valves, actors with electrical energy. The power electronic semiconductor device 14 may also be part of an electrical propulsion system of the aircraft 10.

Fig. 2 shows a top view of a possible embodiment of the power electronic semiconductor device 14. The power electronic semiconductor device 14 comprises a housing 16, a cooling system 18 with a coolant source 19 such as a fan or pump (in case of fluid cooling loops) for providing a coolant flow 28 and several semiconductor power modules 20.1, 20.2, 20.3 including at least one power switching element, e.g., an IGBT or MOSFET (not shown). In the example shown a first to third power module 20.1-20.3 is shown. Each of the first to third power module 20.1-20.3 has an integrated temperature sensor 22.1, 22.2, 22.3. Thus, first to third temperature sensors 22.1-22.3 are arranged at different locations in the path of the coolant flow 28 generated by the cooling system 18.

In Fig. 2, the coolant flow 28 is indicated by arrows 28.1-28.4 wherein a rising pattern density of the arrows illustrate rising temperatures of the coolant.

Of course, the power electronic semiconductor device 14 may have further power modules and/or further temperature sensors along the coolant flow path.

In the embodiment shown, the temperature sensors 22.1, 22.2, 22.3 are sensors integrated on chips of the power modules 20.1, 20.2, 20.3, such as thermistors or NTCs. In other embodiments, the temperature sensors 22.1, 22.2, 22.3 are other temperature sensitive sensors distributed such that, with reference to the coolant flow, at least one sensor, e.g. the first temperature sensor 22.1, is upstream of a semiconductor power module 20.2 and at least one sensor, e.g., the third temperature sensor 22.3, is downstream of the semiconductor power module 20.2.

As further indicated in Fig. 2, the power electronic semiconductor device 14 comprises a monitoring unit 24 for monitoring the cooling system 18 wherein the monitoring unit 24 is especially configured to monitor the coolant flow status of the cooling system 18. The monitoring unit 24 includes the several temperature sensors 22.1, 22.2, 22.3,... arranged at separate locations along the coolant flow path and a computing unit 26. The computing unit 26 includes a processor 30 and a memory 32 containing a computer program. The computing unit 26 can be part of a control of the power electronic semiconductor device or part of an aircraft control.

The computer program has instructions to cause the monitoring unit to carry out a monitoring method, embodiments of which are explained in more detail below.

The monitoring method is for monitoring the cooling system 18 of the power electronic semiconductor device 14. Embodiments of the power electronic semiconductor device 14 include at least one semiconductor power module 20.1, 20.2, 20.3 (including a power switching element). The cooling system 18 of the power electronic semiconductor device 14 is configured to generate the coolant flow along the coolant flow path over the at least one semiconductor power module 20.1, 20.2, 20.3.

The monitoring method comprises the steps:
a) providing several temperature sensors 22.1, 22.2, 22.3 arranged along the coolant flow path,
b) measuring temperatures at different locations of the coolant flow path by means of the temperature sensors,
c) comparing an actual temperature difference between the temperatures measured in step b) with an expected temperature difference calculated on basis of losses of the at least one semiconductor power module and on basis of nominal coolant flow conditions; and
d) determining the status of the coolant flow on basis of the comparison of step c).

In some embodiments of the monitoring method, the inlet and outlet temperature (Tin and Tout) of the coolant is measured and compared to the expected differential temperature. The differential temperature estimation is based on calculated losses of the modules 20.1, 20.2, 20.3, the properties of the coolant and the flow rate. In some embodiments, also a temperature change (over time) is determined for at least one, several or all of the temperature sensors 22.1, 22.2, 22.3,... and compared with expected corresponding temperature changes. For example, the temperature measured by first temperature sensor 22.1 indicates the input temperature Tin, and the temperature measured by the last temperature sensor in the cooling flow path indicates the output temperature Tout. Further, a mean temperature of all temperature sensors 22.1-22.3 and/or a temperature difference between at least two of the temperature sensors 22.1, 22.2, 22.3 are determined in some embodiments.

In some embodiments, expected values are calculated according to at least one or several of the following steps:
c1) calculating an expected temperature difference on basis of a power loss in the at least one semiconductor module 20.1, 20.2, 20.3;
c2) calculating the expected temperature difference on basis of the properties of the coolant;
c3) calculating the expected temperature difference on basis of the intended or nominal coolant flow rate;
c4) calculating an expected mean temperature of the temperature values to be measured by the temperature sensor on basis of the losses and the nominal flow conditions;
c5) calculating an expected temperature change (over time) for at least one, several or all of the temperature sensors 22.1, 22.2, 22.3 on basis of
   c5.1 the power loss of the at least one semiconductor module 20.1, 20.2, 20.3, and/or
   c5.2 the properties of the coolant; and/or
   c5.3 the intended or nominal coolant flow rate.

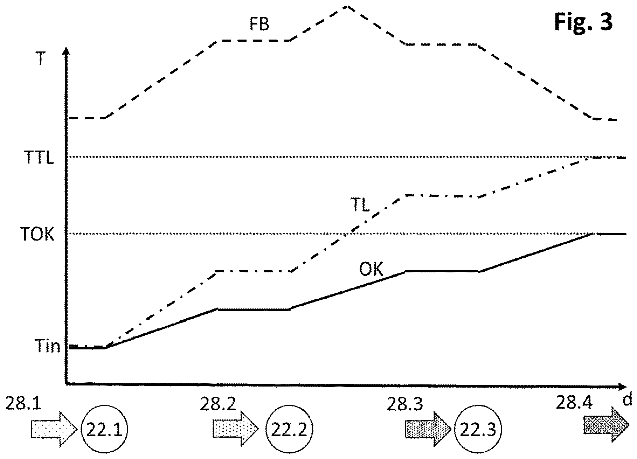

Fig. 3 is a graph showing examples of measured first to third temperatures measured by the first to third temperature sensor 22.1, 22.2, 22.3 over the sensor position. The sensor position is for example the distance d from the coolant source, or in other words the location of the temperature sensor 22.1, 22.2, 22.3 along the coolant flow path.

Fig. 3 shows three examples of the course of measured actual temperatures T over the distance d from the coolant source for three different statuses of the coolant flow. The continuous line OK shows the actual temperatures under nominal coolant flow, i.e., the coolant flow is okay. The dash-dotted line TL shows the actual temperatures when the coolant flow is too low. And the broken line FB shows the actual temperatures when the coolant flow is blocked. Further thresholds TOK for Tout (flow o.k.) and TTL for Tout (flow too low) are shown.

When the coolant flow is okay, Tout-Tin is according to estimated losses and flow.

When the coolant flow is too low, Tout-Tin is higher than the expected value, and the mean temperature is higher than the expected value.

When the coolant flow is blocked, Tout-Tin is lower than the expected value, the mean temperature of all sensors is higher than the expected value, and the temperature change is much steeper compared to the expectation.

Accordingly, by determining at least some of the aforementioned conditions, the coolant flow status is determined in preferred embodiments of the monitoring method.

In some embodiments, the monitoring unit 24 determines that the coolant flow is okay when the first, the first and the second or all of the following conditions are fulfilled:
- the actual temperature difference is the expected temperature difference or within a predetermined temperature difference range determined on basis of the expected temperature difference,
- the actual mean temperature is equal or lower than the expected mean temperature or equal or lower than a predetermined mean temperature threshold determined on basis of the expected mean temperature; and
- the actual temperature change for at least one of the temperature sensors 22.1, 22.2, 22.3 is equal or smaller than the corresponding expected temperature change or equal or smaller than a predetermined temperature change threshold determined on basis of the corresponding expected temperature change.

For all other cases, a warning (signal) that the coolant flow is not okay may be issued.

In some embodiments, the monitoring unit 24 determines that the coolant flow is too low when one, especially the first, or both of the following conditions are fulfilled:
- the actual temperature difference is higher than the expected temperature difference or higher than a predetermined temperature difference threshold determined on basis of the expected temperature difference, and
- the actual mean temperature is higher than the expected mean temperature or a predetermined mean temperature threshold determined on basis of the expected mean temperature.

In some embodiments, the monitoring unit 24 determines that the coolant flow is blocked when the actual temperature difference is lower than the expected temperature difference or lower than a predetermined temperature difference threshold determined on basis of the expected temperature difference.

In some embodiments, the monitoring unit 24 determines that the coolant flow is blocked when at least two or all of the following conditions are fulfilled:
- the actual temperature difference is lower than the expected temperature difference or lower than a predetermined temperature difference threshold determined on basis of the expected temperature difference, and
- the actual mean temperature is higher than the expected mean temperature or a predetermined mean temperature threshold determined on basis of the expected mean temperature;
- the actual temperature change for at least one of the temperature sensors 22.1, 22.2, 22.3 is steeper than the expected temperature slope or steeper than a predetermined temperature change threshold determined on basis of the expected temperature change.

The invention relates to a method for monitoring a cooling system for power electronics, especially on aircraft. For improving monitoring of a cooling system (18) of a power electronic semiconductor device (14) for use on aircraft, wherein the cooling system (18) is configured to generate a coolant flow (28, 28.1-28.4) along a coolant flow path over at least one semiconductor power module (20.1-20.3) of the power electronic semiconductor device, the invention proposes a method with the steps:
a) providing several temperature sensors (22.1-22.3) arranged along the coolant flow path,
b) measuring temperatures at different locations of the coolant flow path by means of the temperature sensors (22.1-22.3),
c) comparing an actual temperature difference between at least two of the temperatures measured in step b) with an expected temperature difference calculated on basis of losses of the at least one semiconductor power module (20.1-20.3) and on basis of nominal coolant flow conditions;
d) determining the status of the coolant flow on basis of the comparison of step c).

**Reference sign list:**
- 10: aircraft
- 12: electronic device
- 14: power electronic semiconductor device
- 16: housing
- 18: cooling system
- 19: coolant source
- 20: power module
- 20.1: first power module
- 20.2: second power module
- 20.3: third power module
- 22.1: first temperature sensor
- 22.2: second temperature sensor
- 22.3: third temperature sensor
- 24: monitoring unit
- 26: computing unit
- 28, 28.1-28.4: coolant flow
- 30: processor
- 32: memory
- d: distance (sensor position)
- FB: actual temperature when the coolant flow is blocked
- OK: actual temperature under nominal coolant flow
- T: temperature
- Tin: inlet temperature
- TL: actual temperature when the coolant flow is too low
- TOK: Tout (flow o.k.)
- Tout: outlet temperature
- TTL: Tout (flow too low)

## Claims

1. Monitoring method for monitoring a cooling system (18) of a power electronic semiconductor device (14) that includes at least one semiconductor power module (20.1-20.3) including a power switching element and the cooling system (18) configured to generate a coolant flow (28, 28.1-28.4) along a coolant flow path over the at least one semiconductor power module (20.1-20.3), comprising:
a) providing several temperature sensors (22.1-22.3) arranged along the coolant flow path,
b) measuring temperatures at different locations of the coolant flow path by means of the temperature sensors (22.1-22.3),
c) comparing an actual temperature difference between temperatures measured in step b) with an expected temperature difference calculated on basis of losses of the at least one semiconductor power module (20.1-20.3) and on basis of nominal coolant flow conditions;
d) determining the status of the coolant flow on basis of the comparison of step c).

2. Monitoring method according to claim 1, wherein step a) comprises at least one or several of the steps:
a1) providing at least one, some or all of the temperature sensors (22.1-22.3) integrated on several semiconductor modules (20.1-20.3) arranged along the coolant flow path;
a2) providing an upstream temperature sensor (20.1) on a position of the coolant medium flow path upstream of the at least one semiconductor power module (20.2) and a downstream temperature sensor (20.3) on a position of the coolant flow path downstream of the at least one semiconductor power module (20.2);
a3) providing first, second, and third temperature sensors (22.1-22.3) along at least a portion of the coolant flow path.

3. Monitoring method according to any of the preceding claims, wherein step b) comprises at least one or several of the steps:
b1) measuring an inlet temperature (Tin) and an outlet temperature (Tout) of the coolant;
b2) measuring a temperature at the position of the at least one semiconductor power module (20.1-20.3);
b3) determining a mean temperature of temperatures measured by the several temperature sensors (22.1-22.3);
b4) determining a temperature change over time for at least one, several or all of the temperature sensors (22.1-22.3).

4. Monitoring method according to any of the preceding claims, wherein step c) comprises at least one or several of the steps:
c1) calculating an expected temperature difference on basis of a power loss within the at least one semiconductor module (20.1-20.3);
c2) calculating the expected temperature difference on basis of the properties of the coolant;
c3) calculating the expected temperature difference on basis of the intended or nominal coolant flow rate;
c4) calculating an expected mean temperature of the temperature values to be measured by the temperature sensors (22.1-22.3) on basis of the losses and the nominal flow conditions;
c5) determining the actual temperature difference on basis of a difference between an outlet temperature (Tout) and an inlet temperature (Tin) of the coolant;
c6) determining a difference between the actual temperature difference and the expected temperature difference and comparing the difference with a tolerance threshold;
c7) comparing an actual temperature change over time with an expected temperature change over time for at least one, several or all of the temperature sensors (22.1, 22.2, 22.3);
c8) determining thresholds for the temperature difference, the mean temperature and the temperature change on basis of calculated losses and nominal coolant flow conditions.

5. Monitoring method according to any of the preceding claims, wherein step d) comprises at least one or several of the steps:
d1) determining that the coolant flow is okay when the actual temperature difference is the expected temperature difference or within a predetermined temperature difference range determined on basis of the expected temperature difference;
d2) determining that the coolant flow is okay when both of the following conditions are fulfilled:
• the actual temperature difference is the expected temperature difference or within a predetermined temperature difference range determined on basis of the expected temperature difference, and
• the actual mean temperature is equal or lower than the expected mean temperature or equal or lower than a predetermined mean temperature threshold determined on basis of the expected mean temperature;
d3) determining that the coolant flow is okay when all of the following conditions are fulfilled:
• the actual temperature difference is the expected temperature difference or within a predetermined temperature difference range determined on basis of the expected temperature difference,
• the actual mean temperature is equal or lower than the expected mean temperature or equal or lower than a predetermined mean temperature threshold determined on basis of the expected mean temperature; and
• the actual temperature change is equal or smaller than the expected temperature change or equal or smaller than a predetermined temperature change threshold determined on basis of the expected temperature change.

6. Monitoring method according to any of the preceding claims, wherein step d) comprises at least one or several of the steps:
d4) determining that the coolant flow is too low when the actual temperature difference is higher than the expected temperature difference or higher than a predetermined temperature difference threshold determined on basis of the expected temperature difference;
d5) determining that the coolant flow is too low when one or both of the following conditions are fulfilled:
• the actual temperature difference is higher than the expected temperature difference or higher than a predetermined temperature difference threshold determined on basis of the expected temperature difference, and
• the actual mean temperature is higher than the expected mean temperature or a predetermined mean temperature threshold determined on basis of the expected mean temperature.

7. Monitoring method according to any of the preceding claims, wherein step d) comprises at least one or several of the steps:
d6) determining that the coolant flow is blocked when the actual temperature difference is lower than the expected temperature difference or lower than a predetermined temperature difference threshold determined on basis of the expected temperature difference;
d7) determining that the coolant flow is blocked when at least two or all of the following conditions are fulfilled:
• the actual temperature difference is lower than the expected temperature difference or lower than a predetermined temperature difference threshold determined on basis of the expected temperature difference, and
• the actual mean temperature is higher than the expected mean temperature or a predetermined mean temperature threshold determined on basis of the expected mean temperature;
• the actual temperature change is steeper than the expected temperature change or steeper than a predetermined temperature change threshold determined on basis of the expected temperature change.

8. Monitoring unit (24) for monitoring a cooling system (18) of a power electronic semiconductor device (14) that includes at least one semiconductor power module (20.1-20.3) including a power switching element and the cooling system (18) configured to generate a coolant flow (28, 28.1-28.4) along a coolant flow path over the at least one semiconductor power module (20.1-20.3), the monitoring unit (24) comprising:
several temperature sensors (22.1-22.3) arranged along the coolant flow path, and
a computing unit (26) configured to compare an actual temperature difference between temperatures measured by the several temperature sensors along the coolant flow path with an expected temperature difference calculated on basis of losses of the at least one semiconductor power module and on basis of nominal coolant flow conditions and for determining the status of the coolant flow on basis of this comparison.

9. Monitoring unit (24) according to claim 8, configured to conduct steps b) to d) of the monitoring method according to any of the claims 1 to 7.

10. Power electronic semiconductor device (14) comprising a cooling system (18), at least one semiconductor power module (20.1-20.3) including a power switching element, and a monitoring unit (24) according to any of the claims 8 or 9.

11. Power electronic semiconductor device (14) according to claim 10, comprising several semiconductor power modules (20.1-20.3), wherein the cooling system (18) is configured to generate the coolant flow over the semiconductor power modules (20.1-20.3) so that coolant flows from one module to the other, and wherein at least some or all of the temperature sensors (22.1-22.3) of the monitoring unit (24) are integrated in the semiconductor power modules (20.1-20.3).

12. Power electronic semiconductor device (14) according to any of the claims 10 or 11, further comprising a housing (16), wherein the cooling system (18) is configured to provide a coolant flow (28, 28.1-28.4) within the housing (16) and the temperature sensors (22.1-22.3) are in direct or indirect contact with the coolant.

13. Aircraft (10) comprising a power electronic semiconductor device (14) according to any of the claims 10 to 12 and/or a monitoring unit (24) according to any of the claims 8 or 9.

14. Computing unit (26) for a monitoring unit (24) according to any of the claims 8 or 9, configured to control the monitoring unit (24) to conduct steps b) to d) of the monitoring method according to any of the claims 1 to 7.

15. Computer program comprising instructions to cause the power electronic semiconductor device (14) of any of the claims 10 to 12 or the monitoring unit (24) of any of the claims 8 or 9 to execute the steps b) to d) of the method of any of the claims 1 to 7.
